# EUROPEAN PATENT SPECIFICATION

(11) **EP 2 141 025 B1**
(45) Date of publication and mention of the grant of the patent: **27.09.2017**
(21) Application number: 08740292.1
(22) Date of filing: 11.04.2008
(51) Int. Cl.: G03F 7/40, B41N 1/12, B41N 3/03, G03F 7/00

(54) **METHOD FOR PRODUCTION OF PHOTOSENSITIVE RESIN PLATE HAVING CONCAVE-CONVEX SHAPE OR LETTERPRESS PRINTING PLATE, AND PRINTING SURFACE TREATMENT SOLUTION FOR USE IN THE METHOD**
VERFAHREN ZUR HERSTELLUNG EINER LICHTEMPFINDLICHEN HARZPLATTE MIT KONKAV-KONVEXER FORM ODER EINER HOCHDRUCKPLATTE SOWIE DRUCKOBERFLÄCHENBEHANDLUNGSLÖSUNG ZUR VERWENDUNG IN DIESEM VERFAHREN
PROCÉDÉ DE FABRICATION D'UNE PLAQUE DE RÉSINE PHOTOSENSIBLE AYANT UNE FORME CONCAVO-CONVEXE OU D'UNE PLAQUE D'IMPRESSION TYPOGRAPHIQUE, ET SOLUTION DE TRAITEMENT DE SURFACE D'IMPRESSION POUR UNE UTILISATION DANS LE PROCÉDÉ

(30) Priority: 19.04.2007 JP 2007110895
(43) Date of publication of application: 06.01.2010
(73) Proprietor: Asahi Kasei Kabushiki Kaisha, Chiyoda-ku Tokyo 101-8101 (JP)
(72) Inventor: MATSUSHITA, Norimitsu, Tokyo 100-8440 (JP)
(74) Representative: Strehl Schübel-Hopf & Partner
(86) International application number: PCT/JP2008/057195
(87) International publication number: WO 2008/133055

(56) References cited:
- EP-A1- 0 775 330
- WO-A1-2007/013475
- JP-A- 59 138 454
- JP-A- 2005 084 418
- US-A1- 2005 106 440
- US-B1- 6 593 058

## Description

### Technical Filed

The present invention relates to a process for producing a relief printing plate, and to the use of a plate surface treatment solution for reducing an ink-fouling on this printing plate. More particularly, the present invention relates to a process for producing a relief printing plate suitable for, for example; preparation of a relief image for a flexo printing plate, a letterpress printing plate, and a stamping plate; formation of a surface-process pattern such as an emboss process; formation of a pattern for molding; formation of a conductive, a semi-conductive, and an insulating pattern of an electronic part; an anti-reflection film in optical parts; a color filter; and formation of a pattern of a functional material such as a filter to cut a (near)infrared light. The suitable application further includes an orientated film used in production of a display element such as a liquid crystal display and an organic electroluminescence display; an underlayer; a luminescence layer; an electron transport layer; formation of a coat film and a pattern of a sealant layer; a blanket for an ink transcription without forming a pattern; and a roll of an ink amount control in contact with an anilox roll. The present invention also relates to the use of a plate surface treatment solution for reducing an anti-fouling on the relief printing plate.

### Background Art

There are various printing methods, wherein relief printing methods (such as a flexo printing method and a letterpress printing method), a gravure (concavity) printing method, an offset (planographic) printing method, and the like, are generally known. In particular, a relief printing method is simple and cheap in printing, can be applied to various materials to be printed, and is facile in a high speed printing, and thus its importance among printing methods is increasing in recent years. Further in particular, an flexo printing method used for printing a carton box, a paper container, a paper bag, a packaging material such as a flexible packaging film, a wall paper, a construction material such as a decoration board or a label print, is drawing an attention in recent years among various relief printing methods because of its high precision and wide
applicability. Photosensitive resin printing plates generally used for flexo printing are produced, for example, as described in Patent Documents 1 to 3, via an exposure step for plate making, a development step, and a post-exposure step, wherein a photosensitive resin is used in many cases. Also there is a method to form a relief image directly on an original printing plate by using a laser without development. Materials used for them may include a synthetic rubber such as EPDM, a heated and vulcanized silicone, and, as described in Patent Document 4, a photosensitive resin photo-cured by a light-exposure.

In addition, a photosensitive resin printing plate may be applicable not only to a relief printing plate but also to various uses including; formation of a pattern using a design roll for surface process such as an emboss process; formation of a pattern for molding; formation of a conductive, a semi-conductive, and an insulating pattern of an electronic part; an anti-reflection film in optical parts; a color filter; and formation of a pattern of a functional material such as a filter to cut a (near)infrared light. Examples of application may further include an orientated film used in production of a display element such as a liquid crystal display and an organic electroluminescence display; an underlayer; a luminescence layer; an electron transport layer; formation of a coat film and a pattern of a sealant layer; a blanket for an ink transcription without forming a pattern; and a roll of an ink amount control in contact with an anilox roll.

For example, in a printing method using a photosensitive resin printing plate for flexo printing, an ink is supplied by an ink supplying roll onto a surface of a convex part of a printing plate having a concave-convex surface, then the printing plate is contacted with a base material thereby transferring the ink adhered on the convex surface to the base material. In flexo printing like this, an ink is often adhered to a convex shoulder of a printing plate or goes into a concave part during a long period of printing thereby resulting in printing on a part of picture not intended to be printed in a certain case (this phenomenon is hereinafter referred to as "ink-blotting"). In another case, a foreign material such as paper powders or dirt is adhered on a convex surface thereby resulting in not printing on a part intended to be printed (this phenomenon is hereinafter referred to as "plate surface blemish").

In these cases, printing must be stopped once and a printing plate surface needs to be wiped with a cloth and the like by using a cleaning liquid such as alcohol. This is economically disadvantageous. Various methods have been proposed to address the plate surface blemish of a printing plate.

For example, a technique to adhere an organic fluorinated compound (Patent Document 5), or a mixture of a water-base emulsion of a silicon compound or a fluorinated compound and an aqueous resin (Patent Document 6), on a printing plate surface with a blush or a spray is described.

In Patent Document 7, a technique to adhere a silicon compound or a fluorinated compound to a printing plate surface before a post-exposure step is described.

In Patent Document 8, a method in which a solution containing a modified silicone compound or a fluorinated compound is contacted with a printing plate surface after an exposure step for plate making of a water-developable photosensitive resin printing plate used for relief printing is proposed.
Patent Document 1: Japanese Patent Laid-Open No. 10-171111
Patent Document 2: Japanese Patent Laid-Open No. 63-088555
Patent Document 3: Japanese Patent Laid-Open No. 05-134410
Patent Document 4: WO 03/022594 pamphlet
Patent Document 5: Japanese Patent Laid-Open No. 51-40206
Patent Document 6: Japanese Patent Laid-Open No. 2002-292985
Patent Document 7: Japanese Patent Laid-Open No. 2005-84418
Patent Document 8: WO 05/064413 pamphlet
EP 0775 330 B1 discloses a process for producing a water-less lithographic plate coated with a photocured composition.

### Disclosure of the Invention

### Problems to be Solved by the Invention

However, even with technologies proposed so far, it has been difficult to produce a photosensitive resin having a durable resistance to an ink-blotting or a plate surface blemish during printing, a good paper-powder releasability, and no adverse effects on printing.

For example, a plate surface treatment solution described in Patent Documents 5 and 6 is applied after a post-exposure step, and thus its durable effect is small. In addition, a work is necessary to wipe out a silicon compound or a fluorinated compound adhered on a convex part in advance of printing, and thus it is economically disadvantageous.

A plate surface treatment solution described in Patent Document 7 is adhered on a printing plate surface and penetrates near the plate surface, and thus a selection of a solvent that penetrates into the plate surface is necessary. When water is used as a solvent, it is necessary to add a water-soluble paraffin or glycol ether, or a nonionic surfactant having a high penetration power, in order to express a penetration action onto the plate surface similar to that mentioned above.

A plate surface treatment solution described in Patent Document 8 is applicable to a water-developable photosensitive resin printing plate, but further improvement in durability of resistances to an ink-blotting and a plate surface blemish during printing is requested.

A technical object of the present invention is to provide a process for producing a relief printing plate having durable resistance to an ink-blotting or a plate surface blemish during printing, a good paper-powder releasability, and no adverse effects on printing. Another object of the present invention is to provide a plate surface treatment solution for reducing ink-fouling on a relief plate..

### Means for Solving the Problems

The present inventors of the present invention carried out extensive investigation to solve the problems as mentioned above and, as a result, found that the problems may be solved by adhering a fluorinated polymer containing a perfluoroalkyl group having 3 or more and 7 or less carbon atoms on average onto a plate surface of a relief printing plate. Based on this finding, the present invention was accomplished.

Namely, the present invention provides following: 1. A process for producing a relief printing plate, comprising the step of adhering a fluorinated polymer containing a perfluoroalkyl group having 3 or more and 7 or less carbon atoms on average onto a plate surface of the relief printing plate.

Further embodiments of the present invention are listed in the claims.

### Advantageous Effects of the Invention

According to the production process of the present invention, a process for producing a relief printing plate having a durable resistance to an ink-blotting on a plate surface of a relief printing plate, a good paper-powder releasability, and no adverse effects on printing may be provided. Further, according to the present invention, a plate surface treatment solution for reducing ink-fouling on a relief printing plate may be provided.

### Best Mode for Carrying Out the Invention

Hereinafter, the best mode for carrying out the present invention (hereinafter referred to as "the present embodiment") will be explained in detail. Herein, the term "photosensitive resin printing plate" used in the present embodiment refers to a printing plate obtained by using a photosensitive resin raw material, in other words, a printing plate obtained from a photosensitive resin plate by a light-exposure.

A production process of the present embodiment will be explained by referring to, as an example, a photosensitive resin printing plate for flexo printing as a relief printing plate, but is not limited to this, and is also applicable to a relief printing plate that is used for printing and patterning. In particular, the process is preferably applied to a flexo printing plate in which an ink viscosity is relatively low and thereby a plate surface tends to be easily fouled. A relief printing plate in the present embodiment includes; a printing plate to form a relief image by exposing and developing a photosensitive resin (including a photosensitive resin printing plate for flexo printing, for example); and a laser-engraving printing plate to form a relief image directly on an original printing plate by using a laser without going through a development step (including a photo-cured photosensitive resin, a heated and vulcanized synthetic rubber, for example). In particular, the present embodiment is preferable in production of the photosensitive resin printing plate for relief printing in which a post-exposure step is usually executed to remove a surface tackiness.

The photosensitive resin printing plate for flexo printing as a relief printing plate in the present embodiment is the one produced via an exposure step for plate making, a development step, and a post-exposure step, wherein the resin before the exposure step for plate making may be in a state of liquid or a solid at room temperature. A printing plate of a resin heretofore known as a photosensitive resin printing plate may be used.

Generally, a resin composition used in a photosensitive resin printing plate for flexo printing comprises an oligomer or a polymer component, a polymerizable monomer component, a photo-initiator, and a stabilizer. A material used in an oligomer or a polymer component, which influences physical properties of a printing plate to be formed most, varies widely, for example, from a polyurethane type, a polyvinyl alcohol type, a polyester resin type, or a nylon resin type, to a resin system obtained by mixing and dispersing a polar-group containing polymer and a hydrophobic polymer (binder polymer), a hydrophobic polymer, and a thermoplastic elastomer. These oligomer or polymer components may be used singly or in combination of two or more.

A preferable form of the oligomer or the polymer component used in the photosensitive resin printing plate for flexo printing as a relief printing plate in the present embodiment is a thermoplastic elastomer. In view of a molding processability, shortening of a time for making the printing plate, and a reproducibility of an image of a printing plate, a more preferable form may include a thermoplastic elastomer block copolymer comprising a first polymer block containing mainly at least one conjugated diene unit (hereinafter simply referred to as "conjugated diene") and a second polymer block containing mainly at least one vinyl aromatic hydrocarbon unit (hereinafter simply referred to as "vinyl aromatic hydrocarbon"). Herein, the term "thermoplastic elastomer" is meant by a polymer which is plasticized and moldable at high temperature and shows a property as a rubber elastic body at room temperature. The term "mainly" used in the above is meant by a content of 50% or more by weight in a polymer block.

Specific examples of the conjugated diene may include, but are not limited to, butadiene, isoprene, and chloroprene, and in particular, butadiene is preferable in view of an abrasion resistance. These monomers may be used singly or in combination of two or more. In order to further improve a solvent-resistance, a double bond in a conjugated diene may be hydrogenated as needed.

Specific examples of the vinyl aromatic hydrocarbon may include, but are not limited to, a monomer such as styrene, p-methyl styrene, tert-butyl styrene, α-methyl styrene, 1,1-diphenylethylene, and vinyl toluene. In particular, styrene is preferable. These monomers may be used singly or in combination of two or more.

When the first polymer block containing mainly a conjugated diene is a copolymer of a vinyl aromatic hydrocarbon and butadiene, the vinyl aromatic hydrocarbon in the copolymer block may be distributed uniformly or non-uniformly (in the form of taper, for example). A uniformly distributed part and/or a non-uniformly distributed part may be co-present plurally in each block. These polymers may be used singly or in combination of two or more.

Styrene-ethylene-butadiene block copolymer whose conjugated diene block is completely hydrogenated, styrene-ethylene-propylene block copolymer, and the like, may also be used, if necessary, together with the thermoplastic elastomer in an amount not impairing a purpose of the present invention.

A molecular weight of the thermoplastic elastomer is not particularly limited, though preferably determined from a good balance of a molding processability and conservation of solid state of a photosensitive resin composition to be obtained. A preferable range of a number-average molecular weight is 80,000 to 500,000. Here, a number-average molecular weight is the one measured by a gel permeation chromatography (GPC) and converted to a standard polystyrene with the known molecular weight.

As a polymerizable monomer component to be used in a photosensitive resin printing plate for flexo printing in the present embodiment, any monomer heretofore known may be used. A preferable form may include esters of acrylic acid, methacrylic acid, fumaric acid, and maleic acid; derivatives of acryl amide and methacryl amide; an allyl ester; styrene and its derivatives; and an N-substituted maleimide compound. These polymerizable monomer components may be used singly or in combination of two or more.

As a photo-initiator to be used in a photosensitive resin printing plate for flexo printing in the present embodiment, any initiator heretofore known may be used. A preferable form may include various kinds of an organic carbonyl compound, in particular an aromatic carbonyl compound. These photo-initiators may be used singly or in combination of two or more. In addition, the initiator as mentioned above may also be used together with a photo-polymerization initiator of a decaying type or of a hydrogen abstraction type.

Further, the photosensitive resin printing plate for flexo printing in the present embodiment may contain various adjuvant additives including, for example, a plasticizer, a polar-group containing polymer, an inhibitor of thermal polymerization, a UV absorber, an anti-halation material, a light stabilizer, a surface treatment material such as a silicon oil, and a photoluminescence tag (a substance whose energy obtained by excitation with an external energy source is discharged as a light and/or a radioactive ray).

An exposure step for plate making and a development step mentioned in the present embodiment may be performed under heretofore known conditions used in a process for producing the usual photosensitive resin printing plate. A light source for exposure in the exposure step for plate making and the post-exposure step in production of the photosensitive resin printing plate in the present embodiment may include a high-pressure mercury lamp, a UV fluorescent lamp, a carbon arc lamp, a xenon lamp, a zirconium lamp, and a sun light. Specific examples of a development method in the production of the photosensitive resin printing plate in the present embodiment may include:
(i) a development method in which an unexposed part is dissolved or taken off by brushing a printing plate in a developer solution;
(ii) a development method in which an unexposed part is dissolved or taken off by brushing with spraying a developer solution;
(iii) an absorption method by a substrate material such as an unwoven cloth with heating the resin at 40 to 200°C; and
(iv) a take-off method by a shear force of a gas or a fluid.

The development method in production of the photosensitive resin printing plate in the present embodiment may be done by using the method as mentioned above singly or in combination of two or more.

As a material for the laser-engraving printing plate to form a relief image directly on an original printing plate by using a laser, any material heretofore known may be used. Examples thereof may include; a heated and vulcanized synthetic rubber such as EPDM; a heated and crosslinked thermoplastic elastomer such as a polymer block containing mainly a conjugated diene and a polymer block containing mainly a vinyl aromatic hydrocarbon; a photo-cured photosensitive resin which is obtained by photo-crosslinking a thermoplastic elastomer, such as a polymer block containing mainly a conjugated diene and a polymer block containing mainly a vinyl aromatic hydrocarbon, by a UV light; and a photo-cured photosensitive resin comprising a resin which is a plastomer at 20°C, such as a polyurethane proposed in the foregoing Patent Document 4.

In particular, in view of productivity and moldability of the relief printing plate, a photo-cured photosensitive resin is preferable. Any molding method heretofore known may be used for molding of the photosensitive resin. Examples of the method may include; a cast molding method; a method in which a resin is extruded through a nozzle or a dice by a machine such as a pump and an extruder and then its thickness is adjusted by blades; and a method in which a resin is calendar-processed by a roll to adjust the thickness.

The molded photosensitive resin layer is crosslinked by light irradiation to form an original printing plate. Crosslinking by light irradiation may also be done simultaneously with molding. A light source for curing the resin may include a high-pressure mercury lamp, an ultrahigh-pressure mercury lamp, a UV fluorescent lamp, a germicidal lamp, a carbon arc lamp, a xenon lamp, and a metal halide lamp. A wavelength of light to irradiate a photosensitive resin composition layer is preferably 200 nm to 300 nm. A light source for curing the resin may be one, but two or more light source having different wavelengths may also be used because a combination of two or more of such light sources improves a cure performance of a resin in a certain case. The exposure intensity is, for example, 3 to 70 mW/cm², but not particularly limited to it. The exposure intensity mentioned above is the value obtained by a UV illuminometer MO-2 equipped with a UV-35 filter (manufactured by ORC Manufacturing Co., Ltd.).

A thickness of the relief printing plate used for laser-engraving may be set arbitrary according to its intended use, but is preferably 0.1 to 7 mm when used as the relief printing plate. In a certain case, lamination of a plurality of materials with different compositions may also be allowed. Example of the laser may include those emitting a light with the wavelength of near-infrared region, such as a YAG laser, a fiber laser, and a semiconductor laser; an infrared laser such as a carbon dioxide laser; and a visible and UV beam laser. A laser may be radiated continuously or pulse-wise.

In the production process of the present embodiment, a plate surface treatment solution comprising a fluorinated polymer containing a perfluoroalkyl group having 7 or less carbon atoms on average is adhered on a plate surface of the photosensitive resin printing plate or the relief printing plate after an exposure step for plate making.

As a fluorinated polymer used in the present embodiment, there may be mentioned, for example, an acryl copolymer having a perfluoroalkyl group in its side chain; a methacryl copolymer having a perfluoroalkyl group in its side chain; an urethane polymer having a perfluoroalkyl group; and an ester polymer having a perfluoroalkyl group; provided the perfluoroalkylgroup has 3 or more and 7 or less carbon atoms on abverage. A monomer constituting the fluorinated polymer comprises (a1) a monomer having a perfluoroalkyl group and (a2) a monomer having a hydroxy group, an amino group, or an amide group in its structure, in addition to a polymerizable unsaturated bond. Monomers in (a1) and (a2) may be selected from a combination of at least one in each.

The average number of carbon atoms of the perfluoroalkyl group in (a1) is 3 or more and 7 or less in view of an effective ink-blotting resistance. A monomer comprising a single number of carbon atoms or a mixture of monomers comprising two or more numbers of carbon atoms may be allowed, though a monomer comprising a single number of carbon atoms is preferable. The average number of carbon atoms is more preferably 3 to 6 (both inclusive). The average number of carbon atoms can be measured by a ¹⁹F-NMR method.

A structure of the perfluoroalkyl group in (a1) may be a linear or a branched form, but a linear form is preferable. In the case of a branched form, a branching moiety is preferably a short carbon chain and present at the terminal part of the perfluoroalkyl group. The perfluoroalkyl group in (a1) may contain a halogen atom other than a fluorine atom, preferably a chlorine atom among the other halogen atoms. Further, an oxygen atom of an ether linkage or a sulfur atom of a thioether linkage may be present between a carbon-carbon bond in the perfluoroalkyl group.

A monomer (a2) may be exemplified by a hydroxy group-containing monomer such as hydroxyethyl (meth)acrylate, hydroxybutyl (meth)acrylate, and 2-hydroxy-3-chloropropyl (meth)acrylate; an amide group-containing monomer such as (meth)acrylamide and an N-substituted (meth)acrylamide; and an amino group-containing monomer such as a substituted aminoalkyl (meth)acrylate, but are not limited to them.

A number-average molecular weight of the fluorinated polymer is preferably 5,000 or more in view of durable plate surface blemish. In view of coating performance, 50,000 or less is preferable. More preferable range is 5,000 to 30,000 (both inclusive). Here, a number-average molecular weight is the one measured by a gel permeation chromatography (GPC) and converted to a standard polystyrene with the known molecular weight.

A fluorinated polymer of the present embodiment may be produced by the method heretofore known. For example, it may be produced by a polymerization reaction such as a solution polymerization, an emulsion polymerization, or a bulk polymerization.

A monomer unit (a1) or (a2) of a fluorinated polymer in the present embodiment may each be one kind, or two or more kinds as mentioned before. Further, a fluorinated polymer may be any of a block polymer, a random polymer, and a graft polymer, though a preference is given to a random polymer in view of easiness in its synthesis.

A fluorinated polymer used in a plate surface treatment solution in the present embodiment may also be a combination of two or more kinds. The fluorinated polymer is used as its dissolved or dispersed solution in a solvent. A solvent used in the plate surface treatment solution in the present embodiment is preferably water and/or a water-soluble solvent. Specific example of the water-soluble solvent may include such solvents as water, an ether, an ester, an alcohol, a ketone, and an acid, but it is not limited to them. As the solvent used in the plate surface treatment solution in the present embodiment, an alcohol is preferable. In particular, 1-propanol, 2-propanol, and tert-butanol are more preferable. Especially, for a solvent-developable photosensitive resin printing plate like a chlorinated solvent or a hydrocarbon solvent as a developer solution, a compound having a high boiling point is preferable. The solvent may be used singly or in combination of two or more. A surfactant may be added to the foregoing solvent in order to control a wetting property of a printing plate surface at the time of application of the solution. An additive such as an anti-foaming agent, an antioxidant, or a preservative may also be added if necessary.

From a view point of a wetting property of a plate surface treatment solution, a preferred form of the solvent used in the plate surface treatment solution of the present embodiment is a mixture of water and an alcohol with a water content being 5% to 60% by weight (both inclusive) and an alcohol content being 40% to 95% by weight (both inclusive), preferably a water content being 10% to 50% by weight (both inclusive) and an alcohol content being 50% to 90% by weight (both inclusive), and more preferably a water content being 20% to 50% by weight (both inclusive)and an alcohol content being 50% to 80% by weight (both inclusive).

In place of a step of adhering or applying a plate surface treatment solution comprising a fluorinated polymer onto a printing plate surface, the fluorinated polymer may be added to a developer solution for use. Concentration of the fluorinated polymer when it is added in a developer solution is preferably 0.01 to 5% by weight. The concentration when adhering to a printing plate surface without adding to a developer solution is preferably 0.05 to 50% by weight, higher than the case of using it in a developer solution because an adhesion time is shorter as compared with the case in a developer solution.

In the case of not adding a fluorinated polymer into a developer solution, an adhesion to a printing plate surface may be done by spraying the solution; brushing by a brush with the solution; soaking in the solution; a method in which the solution is applied by a cloth or a sponge; a method in which the solution is added into a rinsing solution and then the resulting solution is dropped onto the printing plate surface after development; an the like. This may be done at any stage as far as it is after the development step, though a higher effect may be obtained if it is done before the post-exposure step.

The term "post-exposure" in the present embodiment is meant by a treatment with an active energy beam source such as a high-pressure mercury lamp, a UV fluorescent lamp, a carbon arc lamp, a xenon lamp, a zirconium lamp, and a sun light. It is preferable to mean that an exposure treatment of a printing plate surface after development is made by irradiation of at least an active energy beam with a wavelength of 300 nm or shorter. An active energy beam with a wavelength of 300 nm or longer may also be used jointly if necessary. When these active energy beams with different wavelengths are used jointly, the exposure treatments may be done simultaneously or separately. For example, the post-exposure may be done onto a surface side having a concave-convex shape of the photosensitive resin printing plate or the relief printing plate in an air or in a liquid such as water. In view of a durable plate surface blemish, the exposure is preferably done in an air. An exposure intensity is not particularly limited, but for example, the intensity is 1 to 50 mW/cm². The exposure intensity as mentioned above is the value measured by a UV illuminometer MO-2 equipped with a UV-25 filter (manufactured by ORC manufacturing Co., Ltd.).

Here, a post-exposure in post-treatment steps in production of a laser-engraving printing plate used in the present embodiment may be done by using the same light source as mentioned above.

The contact angle (diiodomethane is used as a probe solution) of the photosensitive resin printing plate or the relief printing plate obtained in this way (except for a laser-engraving printing plate) is preferably 55 to 90 degrees. Further, in order to increase an ink concentration in a solid part, the angle is more preferably 60 to 75 degrees. In the case of a laser-engraving printing plate, the contact angle (diiodomethane is used as a probe solution) is preferably 90 to 120 degrees and more preferably 95 to 110 degrees.

### Examples

Hereinbelow, the present invention will be explained more specifically by Examples and Comparative Examples, but the present invention is not limited to them.

### Reference Example 1

Into a one-liter glass autoclave were added 177.7 g of C₆F₁₃CH₂CHOCOCH=CH₂, 39.4 g of HOC₂H₄OCOCH=CH₂, 62.1 g of (C₂H₅)₂NCH₂CH₂OCOCH=CH₂, 3.2 g of CH₃OCOCH₃=CH₂, 0.7 g of n-dodecylmercaptan, 2.7 g of Plonon 204, 10.8 g of polyoxyethylene olein ether, 107.8 g of dipropylene glycol, 0.7 g of acetic acid, 389.3 g of ion-exchanged water, and 4.3 g of stearyldimethyl ammonium chloride (purity of 63%), and the resulting mixture was stirred at 50°C for 30 minutes. Thereafter, the solution was emulsified by using a high-pressure emulsifier LAB-60-10 TBS (manufactured by APV Gaulin GmbH) at 20 MPa. This emulsified solution (699.2 g) was transferred to the one-liter glass autoclave again, and then added by 0.8 g of 2,2'-azobis[2-(2-imidazolin-2-yl)propane]. Inside the autoclave was replaced with a nitrogen gas under a nitrogen pressure, and then polymerization reaction was carried out with stirring at 50°C for 10 hours to obtain a solution containing a milky white emulsion. The solution was filtered under a pressure by using a filter paper C-63 (manufactured by Advantech Co., Ltd.). The obtained emulsion was diluted to a solid concentration of 0.8% by weight with a solution A (isopropanol/purified water=70.4/29.6% by weight).

The obtained reaction solution (about 10 g) was freeze-dried. The dried product (about 50 mg) was dissolved in about 1.0 mL of CDCl₃ to measure ¹H-NMR and ¹³C-NMR. Thereafter, into the solution after the measurements, a sealed inner tube containing 1.0% by weight/volume of C₆F₆ in CDCl₃ was inserted, and then ¹⁹F-NMR was measured. From the measurements, the product was confirmed as an acrylic fluorinated polymer containing at its side-chain a perfluoroalkyl group having 6 carbon atoms on average. A number-average molecular weight (converted to that of a standard polystyrene) of the fluorinated polymer was 19,000 as measured by a gel permeation chromatography (hereinafter referred to as "GPC"). Here, the GPC measurement was done by using LC-10 (trade name, manufactured by Shimadzu Corporation) with two columns of TSKgel GMHXL (4.6 mm inner diameter and 30 cm length) at an oven temperature of 40°C by using a tetrahydrofurane solvent (1.0 mL/minute).

### Reference Example 2

Into a 100-mL glass ampoule for polymerization were added 8.2 g of C₆F₁₃CH₂CHOCOCH=CH₂, 27.1 of C₉H₁₉OCOCCH₃=CH₂, 13.78 g of a 20% aqueous solution of polyoxyethylene octyl phenyl ether, 6.89 g of a 10% aqueous solution of stearyl triethyl ammonium chloride, 25.83g of purified water, 17.23 g of acetone, 0.18 g of stearylmercaptan, and 0.07 g of 2,2'-azobis(2-methylpropionamidine) dihydrochloride salt. After inside the ampoule was replaced by a nitrogen gas, polymerization reaction was carried out at 60°C for 12 hours to obtain a solution containing an emulsion. This solution was filtered under a pressure by using a filter paper C-63 (manufactured by Advantech Co., Ltd.). The obtained emulsion after filtration was diluted to a solid concentration of 0.8% by weight with a solution B (butanol/purified water/dipropylene glycol=70.4/29.4/0.2% by weight).

The obtained reaction solution (about 10 g) was freeze-dried. The dried product (about 50 mg) was dissolved in about 1.0 mL of CDCl₃ to measure ¹H-NMR and ¹³C-NMR. Thereafter, into the solution after the measurements, a sealed inner tube containing 1.0% by weight/volume of C₆F₆ in CDCl₃ was inserted, and then ¹⁹F-NMR was measured. From the measurements, the product was confirmed as an acrylic fluorinated polymer containing at its side-chain a perfluoroalkyl group having 6 carbon atoms on average. A number-average molecular weight (converted to that of a standard polystyrene) of the fluorinated polymer was 15,000 as measured by a gel permeation chromatography (hereinafter referred to as "GPC"). Here, the GPC measurement was done by using LC-10 (trade name, manufactured by Shimadzu Corporation) with two columns of TSKgel GMHXL (4.6 mm inner diameter and 30 cm length) at an oven temperature of 40°C by using a tetrahydrofurane solvent (1.0 mL/minute).

### Reference Example 3

Into a glass ampoule were added 7.5 g of CₙF₂ₙ₊₁CH₂CH₂OCOCH=CH₂ (here, a reference character "n" is a mixture of integers 6 to 12 with an average of 9) and 12.5 g of cyclohexyl methacrylate, followed by 40 g of Asahiklin AK-225 (CF₃CF₂CHCl₂/CClF₂CF₂CHClF) as a solvent and 0.04 g of azobisisobutyronitrile as a polymerization initiator. The glass ampoule containing this mixture was sealed under a nitrogen purge and then co-polymerization reaction was carried out with shaking the ampoule at 65°C for 15 hours. The obtained copolymer was diluted to a solid concentration of 0.8% by weight with Solvit (trade name, manufactured by MacDermid Inc.).

### Example 1

A cover sheet of AFP-SF (trade name of an unexposed solvent-developable photosensitive resin printing plate, manufactured by Asahi Kasei Chemicals Corp., wherein it has a thickness of 1.70 mm and comprises a thermoplastic elastomer with a number-average molecular weight of 100,000 comprising a polymer block containing mainly styrene and a polymer block containing mainly butadiene) was taken out, and then a negative film was adhered onto a protection layer on the photosensitive resin layer. An entire area was firstly exposed to a UV fluorescent lamp having a central wavelength at 370 nm with an energy amount of 320 mJ/cm² from a support side by using an exposure instrument AFP-1216E (trade name, manufactured by Asahi Kasei Chemical Corp.), and subsequently an image exposure was made through the negative film with an energy amount of 5,000 mJ/cm². An exposure intensity of a UV beam irradiated from the back-exposure side by an underneath lamp, measured on a glass plate by using a UV illuminometer MO-2 equipped with a UV-35 filter (manufactured by ORC Manufacturing Co., Ltd.) was 9.4 mW/cm², and an exposure intensity of a UV beam from the relief-exposure side by using an upper lamp was 11.9 mW/cm².

A negative film image including 1, 2, 3, 5, 10, 30, 50, 60, 70, 80, 90, and 95% and solid part with each of screen ruling 100, 133, and 150 lpi was used.

Thereafter, development was done by using a developer solution Solvit (trade name, an organic solvent based on hydrocarbons manufactured by MacDermid Inc.) and a developing instrument Quick Line 912 (manufactured by Asahi Kasei Chemicals Corp.) at a solution temperature of 30°C.

Immediately after the development, the solution obtained in Reference Example 1 was applied on the printing plate surface by using Bemcot (trade name, manufactured by Asahi Kasei Fibers Corp.) impregnated with the solution in a manner like wiping. After dried at 60°C for 2 hours, a post-exposure was made on its entire surface by using a UV fluorescent lamp with an energy amount of 1,000 mJ/cm², and then by using a germicidal lamp having a central wavelength at 254 nm with an energy amount of 2,000 mJ/cm² to obtain a flexo printing resin plate.

Here, the energy amount of a post-exposure by using a germicidal lamp was calculated from an illumination intensity measured by a MO-2 type instrument equipped with a UV-25 filter.

### Example 2

A flexo printing resin plate was obtained in a similar manner to that in Example 1, except that the operation to apply the solution obtained in Reference Example 1 was done after the post-exposure operation.

### Example 3

A flexo printing resin plate was obtained in a similar manner to that in Example 1, except that the solution obtained in Reference Example 2, instead of Reference Example 1, was used.

### Example 4

A flexo printing resin plate was obtained in a similar manner to that in Example 1, except that the solution obtained in Reference Example 2, instead of Reference Example 1, was used, and the operation to apply the solution was done after the post-exposure operation.

### Comparative Example 1

A flexo printing resin plate was obtained in a similar manner to that in Example 1, except that the solution obtained in Reference Example 3, instead of Reference Example 1, was used.

### Comparative Example 2

A flexo printing resin plate was obtained in a similar manner to that in Example 1, except that the solution obtained in Reference Example 3, instead of Reference Example 1, was used, and the operation to apply the solution was done after the post-exposure operation.

### Comparative Example 3

A flexo printing resin plate was obtained in a similar manner to that in Example 1, except that the step of applying the solution obtained in Reference Example 1 was omitted.

### (2) Evaluation

### (a-1) Evaluation of effects on an ink-blotting resistance 1

In order to evaluate effects on an ink-blotting resistance, a contact angle on a printing plate surface was measured under the conditions described hereinbelow. An obtained flexo printing resin plate was kept in a room controlled at a temperature of 23°C and a relative humidity of 50% for one day for stabilization. The measurement conditions were as following: Instrument: a solid-liquid interface analysis instrument Drop Master 500 with an analysis software FAMAS (trade name, manufactured by Kyowa Interface Science Co., Ltd.) Probe solution: diiodomethane (manufactured by Kanto Chemical Co., Inc.)
Needle: 22G (trade name, a stainless steel pin the surface of which is treated by silicon, manufactured by Kyowa Interface Science Co., Ltd.)
Discharge time: 100 milliseconds
Discharge voltage: 4000 mV

A contact angle was automatically measured and recorded 15 seconds after purified water was contacted with a printing plate. Evaluation was made based on the obtained contact angle as following:
70° or more: ⊚
70° to 60°: ○
60° to 50°: Δ
50° or less: ×

The higher the contact angle, the easier an ink is repelled, and thus preference is given in the descending order from ⊚, ○, Δ, to ×.

### (a-2) Evaluation of effects on an ink-blotting resistance 2

In order to evaluate an ink-blotting during printing, printing was done in the following conditions: Solvent ink: Process X Cyan (trade name, manufactured by Toyo Ink Mfg. Co., Ltd.)
Base Material: XH536 60um (trade name, manufactured by Mobil Co., Ltd.)
Anilox roll: 600 lpi (cell volume: 3.8 cm³/m²)
Cushion tape: 3M 1020 (trade name, manufactured by 3M Company)
Printing rate: 100 m/minute

An obtained flexo printing resin plate after printing of 500 m was observed with a loupe to check the extent of an ink residue at 3% highlight of a dot part and 30% midtone in a concave part of a resin printing plate. Evaluation was made according to the following:
Valley of a concave part is filled with an ink: × Ink is attached only on an upper shoulder layer of a
convex part: ○
Between the above two cases: Δ

The longer the time for an ink to reach a valley of a concave part, the higher the resistance is, and thus Δ is preferable to ×, and ○ is preferable to Δ.

### (a-3) Evaluation of quality of solid printing

A state of an ink mounted on a printed material used in the evaluation (a-2) was evaluated. An ink shielding rate per unit area in a solid image part (an image part of 100% dot area) was measured with an observation of a prescribed reflect light source by using a dot analyzer DA-6000 (trade name, manufactured by Oji Scientific Instruments Co., Ltd.). When the ink shielding rate was 97% or more, it was evaluated as "OK" (good), and when the ink shielding rate was less than 97%, it was evaluated as "NG" (no good). The NG evaluation is such a level that a part without an ink is confirmed visually.

### (b) Durable effects of an ink-blotting resistance

In order to evaluate durable effects of an ink-blotting resistance based on simulation, a plate surface of a resin printing plate obtained in the same manner as (a-2) was rubbed strongly for 40 times with an unwoven cloth impregnated with ethyl alcohol, a typical solvent used as a printing ink and an ink cleaner. Thereafter, evaluation was made in a similar manner to that in (a-1) based on the contact angle as following:
60° or more: ○
50° or less: ×
Between them: Δ

The effect was considered durable when the evaluation result ○ or Δ was obtained. The higher the contact angle, the more the fluorinated treatment solution remains, and thus ○ is preferable to Δ.

### (c) Evaluation of paper-powder releasability

In order to evaluate paper-powder releasability during printing, printing was made under the conditions as described below to evaluate the releasability by using an obtained flexo printing resin plate. In Table 1, the results are shown as "evaluation on paper powders", as will be mentioned later.
Printer: AI-3 flexo printer (manufactured by Iyo Kikai Seisakusyo Co., Ltd.)
Water-base ink: HW571 AQP (trade name, manufactured by Toyo Ink Mfg. Co., Ltd.)
Base Material: Pearl Coat (trade name, coat paper manufactured by Oji Paper Co., Ltd.)
Anilox roll: 600 lpi (cell volume: 3.8 cm³/m²)
Cushion tape: 3M 1020 (trade name, manufactured by 3M Company)
Printing rate: 100 m/minute

When the printing rate reached 100 m/minute, 0.5 g of Pearl Coat (coat paper) was cut into powders with a width of 0.1 to 2.0 mm and a length of 0.1 to 2.0 mm, and they were scattered on the base material and forced to be contacted with the printing plate surface. After 3 minutes, numbers of paper powders on a printed material were counted visually.

A negative film having an image with a solid part dimension of 100×150 mm was used for production of a flexo printing resin plate to be evaluated. The evaluation was made as following based on numbers of paper powders found within the range of this solid part:
50 or more powders: ×
20 to 50 powders: Δ
5 to 20 powders: ○
5 or less powders: ⊚

Observed paper powders mean poor printing performance, and thus Δ is preferable to ×, ○ is preferable to Δ, and ⊚ is preferable to ○.

### (d) Comprehensive evaluation

In each of evaluations (a-1), (a-2), (b), and (c), scores were given 3 for ⊚, 2 for ○, 1 for Δ, and 0 for ×, and comprehensive evaluation was made based on the total score of them. The higher the score, the higher the effects are obtained. However, in (a-3), the score as the comprehensive evaluation was made zero for any of the cases other than ⊚, because repulsion of ink was seen.

Results of evaluation tests obtained in Examples 1 to 4 and Comparative Examples 1 to 3 are shown in Table 1.

**[Table 1]**

| | | Average number of carbon atoms in perfluoroalkyl group | Timing of application of solution | Evaluation (a-1) | Evaluation (a-2) | Evaluation (a-3) | Evaluation (b) | Evaluation on paper powders (c) | Comprehensive evaluation (d) |
|---|---|---|---|---|---|---|---|---|---|
| | Applied solution | | | | | | | | |
| Example 1 | Reference Example 1 | 6 | Immediately after development | ⊚ | ○ | OK | ○ | ⊚ | 10 |
| Example 2 | Reference Example 1 | 6 | After post-exposure | ⊚ | ○ | OK | Δ | ○ | 8 |
| Example 3 | Reference Example 2 | 6 | Immediately after development | ⊚ | ○ | OK | ⊚ | ⊚ | 11 |
| Example 4 | Reference Example 2 | 6 | After post-exposure | ⊚ | O | OK | Δ | ○ | 8 |
| Comparative Example 1 | Reference Example 3 | 9 | Immediately after development | ○ | Δ | OK | Δ | ○ | 6 |
| Comparative Example 2 | Reference Example 3 | 9 | After post-exposure | ○ | Δ | OK | × | Δ | 4 |
| Comparative Example 3 | - | - | - | Δ | × | OK | × | × | 1 |

As can be seen in Table 1, when a fluorinated polymer containing a perfluoroalkyl group having 6 carbon atoms was adhered on a plate surface, a printing plate having a sufficient quality in solid printing with a durable ink-blotting resistance could be obtained. In addition, when the fluorinated polymer was adhered prior to a post-exposure step, a printing plate having a more durable ink-blotting resistance as compared with the other case could be obtained.

### Example 5

ADS-60 (trade name, a photosensitive resin comprising a polyurethane type polymer which is liquid at 20°C, manufactured by Asahi Kasei Chemicals, Corp.) was applied in a sheet form with the thickness of 2.8 mm on a PET film, and then irradiated with a UV beam of a high-pressure mercury lamp in an air on an exposed surface of a photosensitive resin layer. The amount of irradiated energy was 4,000 mJ/cm². The exposure intensity of this was measured by a UV illuminometer MO-2 equipped with a UV-35 filter (manufactured by ORC Manufacturing Co., Ltd.). The photo-cured photosensitive resin layer was pattern-engraved by using a laser engraver ZED-Mini (trade name, manufactured by ZED Co., Ltd.) to obtain a flexo printing plate. A contact angle of the obtained flexo printing plate was measured according to the evaluation methods mentioned in (a-1) evaluation of effects on an ink-blotting resistance 1 and (b) durable effects of an ink-blotting resistance.

Thereafter, the solution obtained in Reference Example 1 was applied on surface of the obtained flexo printing plate by using Bemcot(trade name, manufactured by Asahi Kasei Fibers Corp.) impregnated with the solution in a manner like wiping. Then, by using a post-exposure instrument ALF-200UP, a post-exposure was made on its entire surface by a germicidal lamp having a central wavelength at 254 nm with an energy amount of 2,000 mJ/cm², and subsequently by a UV fluorescent lamp with an energy amount of 1,000 mJ/cm² to obtain a flexo printing plate. A contact angle of the obtained flexo printing plate was measured according to the evaluation methods mentioned in (a-1) evaluation of effects on an ink-blotting resistance 1 and (b) durable effects of an ink-blotting resistance. It was found that the contact angle was increased by 37° and 38°, respectively, as compared with the flexo printing plate prior to adhesion of the solution obtained in Reference Example 1. Accordingly, it was found that the laser-engraving printing plate adhered with the fluorinated polymer containing the perfluoroalkyl group having 6 carbon atoms had also a durable ink-blotting resistance.

### Example 6

A flexo printing resin plate was obtained and evaluated in a similar manner to that in Example 5, except that the operation to apply the solution obtained in Reference Example 1 was done after the post-exposure operation. As a result, it was found that the contact angle of the flexo printing plate after adhesion of the solution obtained in Reference Example 1 was increased by 40° and 32°, respectively, as compared with the flexo printing plate prior to adhesion of the solution. Accordingly, it was found that the laser-engraving printing plate adhered with the fluorinated polymer containing the perfluoroalkyl group having 6 carbon atoms has also a durable ink-blotting resistance.

In addition, it was found that from Example 5 and this Example, in a laser-engraving printing plate too, the durable effects of an ink-blotting resistance were higher when the fluorinated polymer was adhered prior to the post-exposure step than after the post-exposure step.

### Example 7

A flexo printing resin plate was obtained and evaluated in a similar manner to that in Example 5, except that the solution obtained in Reference Example 2, instead of Reference Example 1, was used. As a result, it was found that the contact angle of the flexo printing plate after adhesion of the solution obtained in Reference Example 2 was increased by 42° and 51°, respectively, as compared with the flexo printing plate prior to adhesion of the solution. Accordingly, it was found that the laser-engraving printing plate adhered with the fluorinated polymer containing the perfluoroalkyl group having 6 carbon atoms had also a durable ink-blotting resistance.

### Example 8

A flexo printing resin plate was obtained and evaluated in a similar manner to that in Example 5, except that the solution obtained in Reference Example 2, instead of Reference Example 1, was used, and the operation to apply the solution was done after the post-exposure operation. As a result, it was found that the contact angle of the flexo printing plate after adhesion of the solution obtained in Reference Example 2 was increased by 35° and 16°, respectively, as compared with the flexo printing plate prior to adhesion of the solution. Accordingly, it was found that the laser-engraving printing plate adhered with the fluorinated polymer containing the perfluoroalkyl group having 6 carbon atoms had also a durable ink-blotting resistance.

In addition, it was found that from Examples 5 to 7 and this Example, in a laser-engraving printing plate too, the durable effects of an ink-blotting resistance were higher when the fluorinated polymer was adhered prior to the post-exposure step than after the post-exposure step.

### Comparative Example 4

A flexo printing resin plate was obtained and evaluated in a similar manner to that in Example 5, except that the solution obtained in Reference Example 3, instead of Reference Example 1, was used (Comparative Example 4). As a result, it was found that the contact angle of the flexo printing plate after adhesion of the solution obtained in Reference Example 3 was increased as compared with the flexo printing plate prior to adhesion of the solution, but the difference was 27' and 21°, respectively, smaller than those found in Example 5.

### Comparative Example 5

A flexo printing resin plate was obtained and evaluated in a similar manner to that in Example 6, except that the solution obtained in Reference Example 3, instead of Reference Example 1, was used (Comparative Example 5). As a result, it was found that the contact angle of the flexo printing plate after adhesion of the solution obtained in Reference Example 3 was increased as compared with the flexo printing plate prior to adhesion of the solution, but the difference was 16° and 15°, respectively, smaller than those found in Example 6.

### Industrial Applicability

The present invention provides a process for producing a relief printing plate having a surface with a durable ink-blotting resistance in printing and a good paper-powder releasability without adverse effects on printing.

## Claims

1. A process for producing a relief printing plate, comprising the step of adhering a fluorinated polymer containing a perfluoroalkyl group having 3 or more and 7 or less carbon atoms on average onto a plate surface of the relief printing plate.

2. The process for producing the relief printing plate according to Claim 1, wherein the fluorinated polymer further comprises a hydroxy group, an amino group, or an amide group.

3. The process for producing the relief printing plate according to Claim 1 or 2, comprising the step of adhering a fluorinated polymer containing (a1) a monomer having an unsaturated bond and perfluoroalkyl group, and (a2) a monomer having an unsaturated bond and a hydroxyl group, an amino group, or an amide group, the perfluoroalkyl group having 3 or more and 7 or less carbon atoms on average,
onto a plate surface of the relief printing plate.

4. The process for producing the relief printing plate according to any one of Claims 1 to 3, wherein the thickness of the relief printing plate is from 0.1 mm to 7 mm.

5. A use of a plate surface treatment solution comprising a fluorinated polymer containing a perfluoroalkyl group having 3 or more and 7 or less carbon atoms on average for reducing an ink-fouling on a relief printing plate.

## Patentansprüche

1. Verfahren zur Herstellung einer Reliefdruckplatte mit dem Schritt des Anhaftens eines fluorierten Polymers, welches eine Perfluoralkylgruppe mit im Mittel 3 oder mehr und 7 oder weniger Kohlenstoffatomen enthält, auf eine Plattenoberfläche der Reliefdruckplatte.

2. Verfahren zur Herstellung der Reliefdruckplatte nach Anspruch 1, wobei das fluorierte Polymer weiterhin eine Hydroxygruppe, eine Aminogruppe oder eine Amidgruppe umfasst.

3. Verfahren zur Herstellung der Reliefdruckplatte nach Anspruch 1 oder 2, mit dem Schritt des Anhaftens eines fluorierten Polymers, enthaltend (a1) ein Monomer mit einer ungesättigten Bindung und einer Perfluoralkylgruppe und (a2) ein Monomer mit einer ungesättigten Bindung und einer Hydroxygruppe, Aminogruppe oder Amidgruppe, wobei die Perfluoralkylgruppe im Mittel 3 oder mehr und 7 oder weniger Kohlenstoffatome enthält,
auf eine Plattenoberfläche der Reliefdruckplatte.

4. Verfahren zur Herstellung der Reliefdruckplatte nach einem der Ansprüche 1 bis 3, wobei die Dicke der Reliefplatte von 0,1 bis 0,7 mmm ist.

5. Verwendung einer Plattenoberflächen-Behandlungslösung, umfassend ein fluoriertes Polymer, welches eine Perfluoralkylgruppe mit im Mittel 3 oder mehr und 7 oder weniger Kohlenstoffatomen enthält, zur Verminderung einer Druckfarbenverschmutzung auf einer Reliefdruckplatte.

## Revendications

1. Procédé de fabrication d'une plaque d'impression en relief, comprenant l'étape consistant à faire adhérer un polymère fluoré contenant un groupe perfluoroalkyle contenant 3 ou plus et 7 ou moins atomes de carbone en moyenne sur une surface de plaque de la plaque d'impression en relief.

2. Procédé de fabrication de la plaque d'impression en relief selon la revendication 1, dans lequel le polymère fluoré comprend en outre un groupe hydroxy, un groupe aminé ou un groupe amide.

3. Procédé de fabrication de la plaque d'impression en relief selon la revendication 1 ou 2, comprenant l'étape consistant à faire adhérer un polymère fluoré contenant (a1) un monomère présentant une liaison insaturée et un groupe perfluoroalkyle, et (a2) un monomère présentant une liaison insaturée et un groupe hydroxyle, un groupe aminé ou un groupe amide, le groupe perfluoroalkyle contenant 3 ou plus et 7 ou moins atomes de carbone en moyenne, sur une surface plaque de la plaque d'impression en relief.

4. Procédé de fabrication de la plaque d'impression en relief selon l'une quelconque des revendications 1 à 3, dans lequel l'épaisseur de la plaque d'impression en relief est comprise entre 0,1 mm et 7 mm.

5. Utilisation d'une solution de traitement de surface de plaque comprenant un polymère fluoré contenant un groupe perfluoroalkyle contenant 3 ou plus et 7 ou moins atomes de carbone en moyenne afin de réduire l'encrassement d'encre sur une plaque d'impression en relief.
